# EUROPÄISCHE PATENTANMELDUNG

(11) **EP 3 264 604 A1**
(43) Veröffentlichungstag der Anmeldung: **03.01.2018**
(21) Anmeldenummer: 17178351.7
(22) Anmeldetag: 28.06.2017
(51) Int. Cl.: H03K 17/96

(54) **ELEKTRONISCHER SCHALTER**

(30) Priorität: 28.06.2016 DE 102016111803
(71) Anmelder: Holjac, Marino, 60433 Frankfurt (DE)
(72) Erfinder: Holjac, Marino, 60433 Frankfurt (DE)
(74) Vertreter: Limbeck, Achim

(57) **Zusammenfassung**

Die vorliegende Erfindung betrifft einen elektronischen Schalter (1), der elektrische Geräte schaltet und/oder überwacht, wobei der Schalter (1) ein Schaltnetzteil (10), einen Mikrocontroller (11), eine Wandhalterung (12) sowie ein großflächiges Betätigungselement (13) umfasst und wobei das Betätigungselement (13) mittels einer magnetischen Verbindung an der Wandhalterung (12) gehalten wird.

## Beschreibung

Die vorliegende Erfindung betrifft einen elektronischen Schalter, insbesondere einen Lichtschalter oder -taster mit Nachtlichtfunktion, der elektrische Geräte schaltet und/oder überwacht, wobei der Schalter ein Schaltnetzteil, einen Mikrocontroller, eine Wandhalterung sowie ein großflächiges Betätigungselement umfasst.

### Stand der Technik

Gemäß dem Stand der Technik sind elektronische Schalter unlängst bekannt, bei denen mittels eines kapazitiven Sensors und/oder über Funkempfänger elektrische Geräte geschaltet und/oder überwacht werden. Diese haben sich bereits bestens bewährt. Bei der Montage ist in fast allen Fällen kein Kabelverlegen zum Verbraucher hin notwendig, der Schalter kann ohne irgendwelche Stemmarbeiten durchführen zu müssen, in einer Standard Unterputzdose befestigt werden. Die Anordnung ist absolut kindersicher, ein Elektrisieren ist ausgeschlossen.

### Darstellung der Erfindung

Der vorliegenden Erfindung liegt die Aufgabe zu Grunde, einen Schalter der eingangs genannten Art zu schaffen, der komfortabler in weit mehr Anwendungsfällen eingesetzt werden kann, als die am Markt bekannten Schalter und Taster.

Erfindungsgemäß wird die voranstehende Aufgabe gemäß dem Oberbegriff des Anspruchs 1 in Verbindung mit den kennzeichnenden Merkmalen gelöst. Vorteilhafte Ausgestaltungen und Weiterbildungen des erfindungsgemäßen Schalters sind in den abhängigen Unteransprüchen angegeben.

Erfindungsgemäß ist ein Schalter der eingangs genannten Art dadurch gekennzeichnet, dass das Betätigungselement mittels einer magnetischen Verbindung an der Wandhalterung gehalten wird.

Das Betätigungselement kann als eine unbewegliche, transluzente Frontplatte (Frontblende) in Kombination mit einem kapazitiven Sensor zur vorzugsweise berührungslosen Betätigung durch Annäherung mit der Hand oder über Funk oder alternativ auch als transluzenter, beweglicher Schalter ausgebildet sein, welcher im Randbereich durch eingeformte oder zusätzlich anschlagende Formteile lagebestimmt beweglich innerhalb eines Rahmens gelagert ist.

Durch die magnetische Verbindung der Wandhalterung und des Betätigungselements können bestehende Schalterrahmen und Serien bekannter Hersteller wie z. B. Gira, Merten, Busch Jäger, Kopp usw. weiter genutzt werden, indem einfach das Betätigungselement (bspw. eine Schaltwippe oder eine transluzente Frontplatte) mit der Magnethalterung sowie der mechanische durch den elektronischen Mikrocontroller gesteuerten Schalteinsatz ersetzt wird.

### Kurzbeschreibung der Zeichnungen

Weitere Ziele, Merkmale, Vorteile und Anwendungsmöglichkeiten des erfindungsgemäßen Schalters ergeben sich aus der nachfolgenden Beschreibung eines Ausführungsbeispiels anhand der Zeichnungen.

Dabei bilden alle beschriebenen und/oder bildlich dargestellten Merkmale für sich oder in beliebiger Kombination den Gegenstand der Erfindung, unabhängig von der Zusammenfassung in einzelnen Ansprüchen oder deren Rückbeziehung.

In den Zeichnungen zeigen
Fig.1 den erfindungsgemäßen Schalter in perspektivischer Ansicht als Explosionszeichnung;
Fig.2 die Wandhalterung in perspektivischer Ansicht;
Fig.3 das Betätigungselement in perspektivischer Rückansicht;
Fig.4 das Schaltnetzteil mit integrierten Relais;
Fig.5 den Mikrocontroller mit LED in perspektivischer Ansicht.

### Ausführung der Erfindung

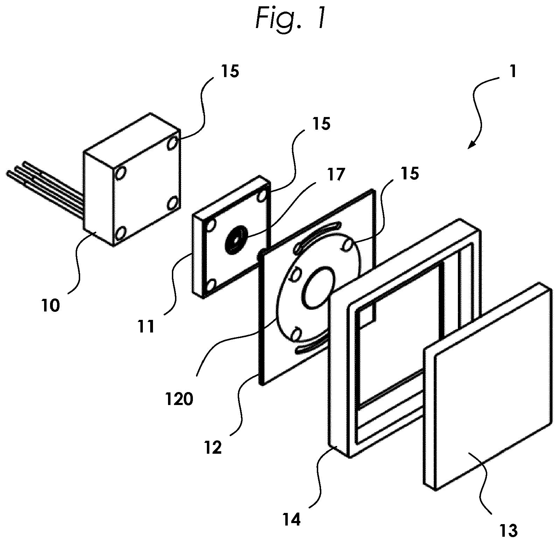

Wie aus Fig.1 ersichtlich, besteht die magnetische Verbindung vorzugsweise aus mehreren an der Wandhalterung 12 angeordneten beabstandeten Magneten 15 oder Haltern aus einem magnetisch anziehbaren Material. Das Schaltnetzteil 10 beinhaltet vorzugsweise mindestens ein Relais und ggf. einen Akkumulator zur autarken Stromversorgung.

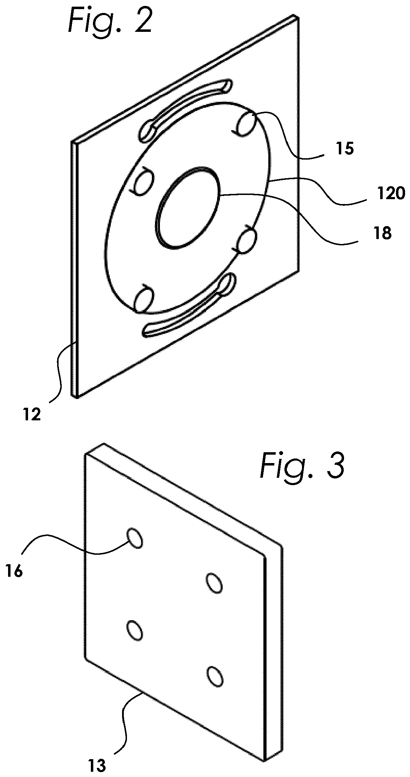

An der Rückseite des Betätigungselements 13, welche in der in den Fign. 1-4 dargestellten Ausführung als transluzente Frontplatte 130 ausgestaltet ist, sind entsprechend korrespondierend angeordnete Magneten 16 oder Halter aus einem magnetisch anziehbaren Material angeordnet, um so eine magnetische Verbindung zwischen dem Betätigungselement 13 und der Wandhalterung 12 zu erreichen.

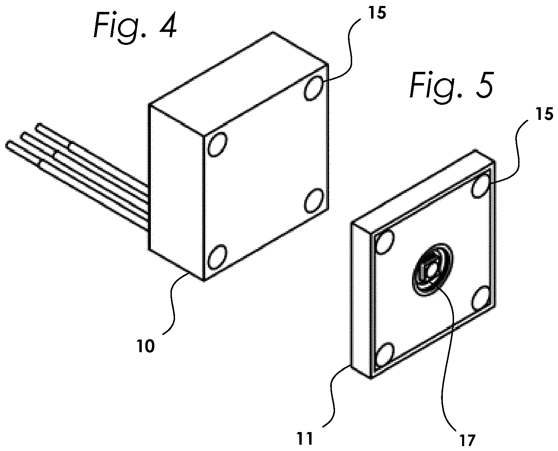

Der Rahmen 14 wird durch die magnetische Verbindung der beiden Teile 12,13 mitgehalten. Darüber hinaus werden gemäß Fig.4 vorzugsweise auch das Schaltnetzteil 10 sowie der Mikrocontroller bzw. das Mikrocontrollergehäuse 11 durch die magnetische Verbindung gehalten.

Wie aus den Fign. 1 bis 5 ersichtlich, sind besonders bevorzugt Magneten 15,16 an dem Schaltnetzteil 10, an dem Mikrocontroller bzw. an dem Mikrocontrollergehäuse 11, an der Wandhalterung 12 und an dem Betätigungselement 13 derart korrespondierend zueinander angeordnet, dass sämtliche Module 10, 11, 12, 13, 14 in Form einer modularen Baugruppe magnetisch miteinander verbunden sind. Der hierdurch erreichte, einfache modulare Aufbau des Schalters 1 kann somit durch Austausch einzelner Module 10, 11, 12, 13, 14 jederzeit auf den aktuellen Stand der Technik erweitert werden.

In einer weiteren, vorteilhaften Ausführungsform der Erfindung ist die transluzente Frontplatte 130 als Display (z.B. OLED) ausgeführt.

In einer ganz besonders vorteilhaften Ausführungsform der Erfindung ist innerhalb des Schalters 1, vorzugsweise an dem Mikrocontroller 11, mindestens eine digitale Vollfarb-LED 17 vorgesehen, um die Farbe und die Helligkeit individuell getrennt nach Schaltzustand auf einer vorzugsweise transluzenten Frontplatte 130 des Betätigungselements 13 anzuzeigen.

In einer vorteilhaften Ausführungsform der Erfindung werden spezielle Linsen 18 und Filter eingesetzt, um somit eine sehr helle und gleichmäßige Ausleuchtung der transluzenten Frontplatte 130 zu ermöglichen.

Der Schalter ist auch sehr gut als Nachtlicht verwendbar, bei einem umweltfreundlichen Stromverbrauch von max. vorzugsweise 0,8 W bei max. Helligkeit.

Nähert man sich dem Schalter mit der Hand (ca. 0 bis 5 cm), ändern sich die Eigenschaften in dem elektrischen Feld der dem Befestigungselement 13 und die Schaltung wird ausgelöst.

Die LED leuchtet in der jeweils eingestellten Farbe und Helligkeit und kann separat für jeden Schaltzustand (AN / AUS) eingestellt werden. Die Farbe und Helligkeit kann eingestellt werden, indem man länger als 3 Sekunden (kann im Mikrocontroller-Sketch geändert werden) die Hand vor die Sensorfläche hält. Dadurch wird das Konfigurationsmenü aufgerufen und man kann der Reihe nach die Farbe für den EIN-Schaltzustand, danach für den AUS-Schaltzustand und zum Schluss die Helligkeit einstellen. Über eine Funkverbindung z. B. BLE können diese Einstellungen viel komfortabler per APP vom Handy oder Tablet aus vorgenommen werden.

Über eine Funkverbindung kann vorzugsweise auch per APP vom Handy/Tablet aus auf die Steuer/Regel/Messaufgaben des Mikrocontrollers zugegriffen werden oder bspw. auch eine neue Software/Firmware übertragen werden.

Der Eingang und Ausgang für die Netzspannung (230 V) ist mit WAGO 221-413 Klemmen versehen. Somit ist ein sehr einfacher, schneller und sicherer Anschluss möglich.

Der Mikrocontroller 11 ist frei programmierbar (USB oder BLE) und das System modular aufgebaut und beliebig erweiterbar. Der Mikrocontroller 11 kann in einer vorteilhaften Ausführungsform der Erfindung in die Wandhalterung 12 integriert werden, wobei das Netzteil direkt mit der Wandhalterung 12 verbunden ist. Weiterhin kann der Schalter auch als nicht modulares Komplettsystem aufgebaut sein.

Der Schalter 1 kann durch neue Module jederzeit einfach erweitert und in viele bestehende Hausautomatisierungssteuerungen eingebunden werden.

Der Schalter 1 kann auch für viele andere Zwecke genutzt werden kann z.B. fast alle Mess-, Steuer- und Regelaufgaben und durch die open Source Software auch eigene kreative Ideen umgesetzt werden können.

Vorzugsweise ist ein Schaltnetzteil vorgesehen, welches mit einem Ausgangsüberlast, Temperatur und Kurzschlussschutz und mit einem Leerlaufverlust < 0,1 W ausgestattet ist. In einer weiteren Ausführungsform der Erfindung kann anstelle des Schaltnetzteils auch jede beliebige andere Stromversorgung treten oder auch zusätzlich angebracht sein, z. B. Schalnetzteil und Akkumulator oder ein Batteriefach. Entscheidend hierbei sind alleine die mechanische Anordnung der Stromversorgung und ihre Funktion im System.

In einer weiteren Ausführung ist ein kapazitiver Näherungssensor mit Selbstkalibrierung, automatischer Driftkompensation und Geräuschfilterung vorgesehen.

Vorzugsweise werden Solid State Relays zum Schalten der Ausgangsspannung verwendet, um die galvanische Trennung von Steuerspannung und Schaltspannung zu gewährleisten.

Der erfindungsgemäße Schalter 1 beschränkt sich in seiner Ausführung nicht auf die vorstehend angegebenen bevorzugten Ausführungsformen. Vielmehr sind eine Vielzahl von Ausgestaltungsvariationen denkbar, welche von der dargestellten Lösung auch bei grundsätzlich anders gearteter Ausführung Gebrauch machen.
- 1: Schalter
- 10: Schaltnetzteil
- 11: Mikrocontroller
- 12: Wandhalterung
- 13: Betätigungselement
- 14: Rahmen
- 15: Magneten / Halter aus einem magnetisch anziehbaren Material
- 16: Magneten/ Halter aus einem magnetisch anziehbaren Material
- 17: LED
- 18: Linse
- 120: Sensorfläche
- 130: Frontplatte / Frontblende des Betätigungselements

## Patentansprüche

1. Elektronischer Schalter (1), der elektrische Geräte schaltet und/oder überwacht, wobei der Schalter (1) ein Schaltnetzteil (10), einen Mikrocontroller (11), eine Wandhalterung (12) sowie ein großflächiges Betätigungselement (13) umfasst,
**dadurch gekennzeichnet, dass**
das Betätigungselement (13) mittels einer magnetischen Verbindung an der Wandhalterung (12) gehalten wird.

2. Elektronischer Schalter (1) nach Anspruch 1,
**dadurch gekennzeichnet, dass**
die magnetische Verbindung aus mehreren an der Wandhalterung (12) angeordneten beabstandeten Magneten (15) oder Haltern aus einem magnetisch anziehbaren Material besteht.

3. Elektronischer Schalter (1) nach den Ansprüchen 1 und 2,
**dadurch gekennzeichnet, dass**
an der Rückseite des Betätigungselements (13) entsprechend korrespondierend angeordnete Magneten (16) oder Halter aus einem magnetisch anziehbaren Material angeordnet sind, um so eine magnetische Verbindung zwischen dem Betätigungselement (13) und der Wandhalterung (12) zu erreichen.

4. Elektronischer Schalter (1) nach Anspruch 3,
**dadurch gekennzeichnet, dass**
der Rahmen (14) durch die magnetische Verbindung der beiden Teile (12,13) mitgehalten wird.

5. Elektronischer Schalter (1) nach einem der vorangegangenen Ansprüche,
**dadurch gekennzeichnet, dass**
innerhalb des Schalters (1), vorzugsweise an dem Mikrocontroller (11), mindestens eine digitale Vollfarb-LED (17) vorgesehen ist, um die Farbe und die Helligkeit individuell getrennt nach Schaltzustand auf einer vorzugsweise transluzenten Frontplatte (130) des Betätigungselements (13) anzuzeigen.

6. Elektronischer Schalter (1) nach einem der vorangegangenen Ansprüche,
das Betätigungselement (13) als transluzente Frontplatte (130) ausgestaltet ist.

7. Elektronischer Schalter (1) nach Anspruch 6,
**dadurch gekennzeichnet, dass**
die transluzente Frontplatte (130) als Display z.B. OLED ausgeführt ist.

8. Elektronischer Schalter (1) nach einem der vorangegangenen Ansprüche 6 oder 7,
**dadurch gekennzeichnet, dass**
Linsen (18) und Filter vorgesehen sind, um eine sehr helle und gleichmäßige Ausleuchtung der transluzenten Frontplatte (130) zu ermöglichen.

9. Elektronischer Schalter (1) nach einem der vorangegangenen Ansprüche 2 bis 8,
**dadurch gekennzeichnet, dass**
Magneten (15,16) an dem Schaltnetzteil (10), an dem Mikrocontroller bzw. an dem Mikrocontrollergehäuse (11), an der Wandhalterung (12) und an dem Betätigungselement (13) derart korrespondierend angeordnet sind, dass sämtliche Bauteile (10, 11, 12, 13, 14) in Form einer modularen Baugruppe magnetisch miteinander verbunden sind.
